Europäisches Patentamt

European Patent Office

Office européen des brevets

(11) Veröffentlichungsnummer: **0 289 888**
**A2**

## EUROPÄISCHE PATENTANMELDUNG

(21) Anmeldenummer: 88106535.3

(22) Anmeldetag: 23.04.88

(51) Int. Cl.⁴: **H05K 7/20**

(30) Priorität: 07.05.87 DE 3715137

(43) Veröffentlichungstag der Anmeldung:
09.11.88 Patentblatt 88/45

(84) Benannte Vertragsstaaten:
**DE ES FR GB IT**

(71) Anmelder: **Schauer, Franz**
**Mörikestrasse 95**
**D-7440 Nürtingen-Zizishausen(DE)**

(72) Erfinder: **Schauer, Franz**
**Mörikestrasse 95**
**D-7440 Nürtingen-Zizishausen(DE)**

(74) Vertreter: **Möbus, Rudolf, Dipl.-Ing.**
**Hindenburgstrasse 65**
**D-7410 Reutlingen(DE)**

(54) **Montageträger mit elektrischer Überwachungsschaltung für Heizkreise.**

(57) Der mit einer elektrischen Überwachungs-schaltung versehene Montageträger (10) für Heiz-kreise ist so ausgebildet, daß die sich erwärmenden stromführenden Schaltungsteile, insbesondere ein Stromwandler (22) und ein kontaktloser Leistungs-schalter (20), getrennt von den übrigen Schaltung-steilen (27) auf einem die Wärme nach außen abfüh-renden Bauteil (13/15) angeordnet sind. Die Überwachungsschaltung ist so ausgelegt, daß sie auf Änderungen der Heizleistungsaufnahme anspricht. Außerdem kann die Überwachungsschaltung einen Sicherungs-und Halbleiter-Überwachungsteil aufwei-sen.

Fig.1

EP 0 289 888 A2

# Montageträger mit elektrischer Überwachungsschaltung für Heizkreise

Die Erfindung betrifft einen Montageträger mit einer elektrischen Überwachungsschaltung für Heizkreise mit mindestens einem kontaktlosen Leistungsschalter.

Heizeinrichtungen für Maschinen, beispielsweise für Kunststoff-Spritzmaschinen, werden heute weitgehend über kontaktlose Schalter, also Halbleiterschaltungen, betätigt. Dabei stellt sich die Aufgabe, die elektrischen Schaltungen zur Überwachung der Heizkreise so anzuordnen und auszubilden, daß sie durch eine von stromführenden Teilen ausgehende unvermeidliche Erwärmung nicht negativ beeinflußt werden und eine ausreichend genaue Überwachung verschiedener Funktionen erlauben.

Die gestellte Aufgabe wird mit einem Montageträger mit Überwachungsschaltung der eingangs genannten Art erfindungsgemäß dadurch gelöst, daß der kontaktlose Leistungschalter und sich erwärmende stromführende Teile der Überwachungsschaltung, insbesondere ein Stromwandler, auf einem die Wärme nach außen abführenden Bauteil oder Teil des Montageträgers angeordnet sind, während die übrigen, keinem starken Stromfluß unterliegenden Schaltungsteile auf gesonderten Trägerteilen montiert sind.

Mit einem erfindungsgemäß ausgebildeten Montageträger wird also erreicht, daß durch Wärmeabfuhr nach außen eine die Überwachungsschaltung beeinflussende Übererwärmung im Montageträger vermieden wird, so daß in der Überwachungsschaltung relativ wärmeempfindliche Operationsverstärker und andere Halbleiter-Bauelemente eingesetzt werden können. Dabei kann der Montageträger in Anpassung an die Zahl und Größe der zu überwachenden Heizkreise einen unterschiedlichen Aufbau haben. So kann er beispielsweise ein Gehäuse aufweisen, das an der Stelle seiner Anlage gegen eine Trägerschiene eines Schaltgestelles oder Schaltkastens mit einer metallischen Außenwandung versehen ist, auf deren Innenseite die sich erwärmenden Teile der Überwachungsschaltung angeordnet sind. Die wärmeempfindlichen Teile der Überwachungsschaltung können wahlweise in mindestens einem gesonderten Gehäuse angeordnet sein, das auf das die Wärme abführende Gehäuse oder Bauteil aufgesetzt ist und mittels einer direkten oder indirekten Steckverbindung an den im wärmeabführenden Gehäuse untergebrachten Schaltungsteil angekoppelt ist. Die wärmeempfindlichen Schaltungsteile können aber auch in gesonderten Kammern oder Innenraumbereichen eines gemeinsamen Gehäuses auf Leiterplatten angeordnet sein, während die sich erwärmenden Bauteile mit die Wärme nach außen führenden Teilen beispielsweise im Mittelbereich des Gehäuses angeordnet sind. Dies gilt insbesondere für Montageträger, bei welchen eine intensive Wärmeabfuhr nach außen über mindestens einen Kühlrippenkörper erfolgt, der durch eine Öffnung im Montageträgergehäuse nach außen, beispielsweise in einen ansetzbaren Kühlschacht, ragt.

Auf einem erfindungsgemäß ausgebildeten Montageträger lassen sich somit auch empfindliche Überwachungsschaltungen anordnen, die erfindungsgemäß einen Heizleistungs-Überwachungsteil und/oder einen Sicherungs-und Halbleiter-Überwachungsteil umfassen. Der Heizleistungsüberwachungsteil kann vorteilhafterweise so ausgebildet sein, daß er unabhängig von Netzspannungsschwankungen arbeitet, wobei über einen Stromwandler ein vom Heizungsstrom abhängiges Signal und über ein Potentiometer ein von der Netzspannung abhängiges Signal auf getrennte Signalstrecken eingegeben werden können, wobei eine Koppelung der beiden Signalstrecken mittels eines die Aufladezeiten von Kondensatoren in den beiden Signalstrecken synchronisierendes Koppelungs-Potentiometers erfolgen kann und beide Signalstrecken schließlich über als Fensterdiskriminatoren geschaltete Operationsverstärker zu Aufleuchtedioden als Anzeigeorgane führen. Eine zusätzliche Koppelung zwischen den beiden Signalstrecken kann zweckmäßig über einen Kondensator zur Kompensation von durch unterschiedliche Aufladungszeitkonstanten auftretenden Signallaufzeitunterschieden erfolgen. Im Sicherungs-und Halbleiter-Überwachungsteil sind zweckmäßig zwei Eingänge vorgesehen, von denen einer hinter einer Sicherung und vor dem kontakt losen Leistungsschalter und einer hinter dem kontaktlosen Leistungsschalter und vor den Heizungswiderständen angeordnet und jeweils über einen Einweggleichrichter mit der Basis eines Transistors eines Anzeigeteiles verbunden ist.

Mit einem erfindungsgemäß angekoppelten Sicherungs-und Halbleiter-Überwachungsteil der Überwachungsschaltung läßt sich sowohl der Ausfall einer Sicherung als auch ein Defekt im kontaktlosen Leistungsschalter erkennen und anzeigen. Mit dem erfindungsgemäß ausgebildeten Heizleistungs-Überwachungsteil der Überwachungsschaltung kann die den Heizkreisen zugeführte Heizleistung auf auftretende Veränderungen von 100 Watt nach oben oder unten festgestellt werden, die auftreten können, wenn beispielsweise eine Heizpatrone ausfällt oder kurzschließt.

Nachfolgend werden Ausführungsbeispiele erfindungsgemäß ausgebildeter Montageträger und Überwachungsteile der Überwachungsschaltung anhand der beiliegenden Zeichnung näher erläutert.

Im einzelnen zeigen:

Fig. 1 eine Seitenansicht einer ersten Ausführungsform eines Montageträgers bei abgenommener Gehäuseseitenwandung;

Fig. 2 einen Schnitt entlang der Linie II - II in Fig. 1;

Fig. 3 einen Schnitt entlang der Linie III - III in Fig. 1;

Fig. 4 einen Längsschnitt durch ein zweites Ausführungsbeispiel eines Montageträgers;

Fig. 5 einen Blick auf den unteren Gehäuseteil des Montageträgers in der Ebene V - V in Fig. 4;

Fig. 6 ein Schaltbild des Heizleistungs-Überwachungsteiles der Überwachungsschaltung eines Montageträgers;

Fig. 7 das Schaltbild des Sicherungs-und Halbleiter-Überwachungsteiles der Überwachungsschaltung eines Montageträgers.

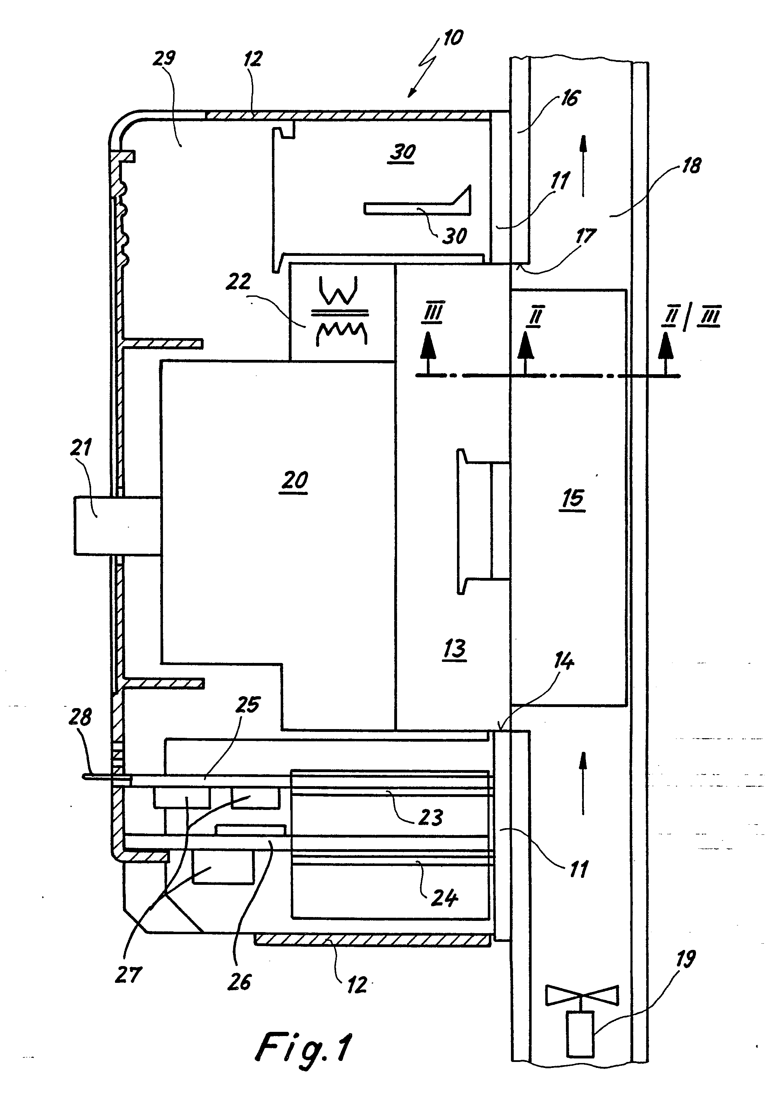

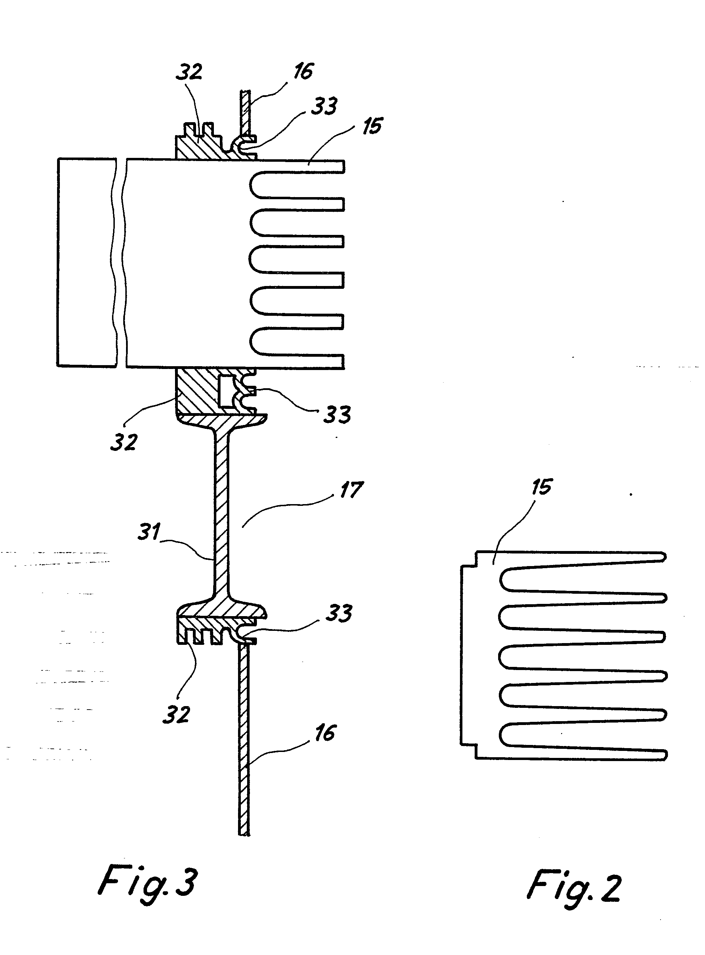

Fig. 1 zeigt einen Montageträger 10, der eine zum Einbau in einen Schaltkasten oder zum Ansetzen an ein Schaltgerüst ausgebildete Montageplatte 11 für die verschiedenen Schaltungsteile einer Überwachungsschaltung und eine die Schaltungsteile schützende, auf die Montageplatte 11 aufsetzbare Gehäusehaube 12 aufweist. Im mittleren Teil der Montageplatte 11 ist in eine zentrale Öffnung 14 dieser Montageplatte eine massive Metallplatte 13 eingesetzt, an welche eine über die Montageplatte 11 hinausragende, gerippte Kühlschiene 15 angesetzt ist, die in Fig. 2 im Querschnitt dargestellt ist. Die Montageplatte 11 ist auf eine Wandung 16 eines Schaltschrankes so aufgesetzt, daß die Kühlschiene 15 durch eine Öffnung 17 dieser Gehäusewandung in einen hinter der Gehäusewandung 16 ausgebilde ten Kühlschacht 18 ragt. Durch diesen Kühlschacht 18 kann Kühlluft durch Konvektion hindurchströmen oder mittels eines angedeuteten Gebläses 19 hindurchgefördert werden.

Auf der massiven Metallplatte 13 ist ein mit einem Sicherungsautomaten gekoppelter kontaktloser Leistungsschalter 20 montiert, wobei ein Sicherungs-Stellknopf 21 durch eine Öffnung der Gehäusehaube 12 nach außen ragt. Außerdem ist auf der massiven Metallplatte 13 ein Stromwandler 22 einer elektrischen Überwachungsschaltung montiert. Die von diesen stromdurchflossenen Teilen erzeugte Wärme wird über die massive Metallplatte 13 und die angrenzende Kühlschiene 15 aus der Gehäusehaube 12 nach außen abgeleitet.

Im unteren Bereich des von der Gehäusehaube 12 umschlossenen Raumes sind an mit der Montageplatte 11 verbundenen Stützwandungen 23 und 24 zwei Leiterplatten 25 und 26 verankert, auf denen Verbindungsleitungen und allgemein mit der Bezugsziffer 27 bezeichnete Schaltungsteile der Überwachungsschaltung montiert sind. Die Gehäusehaube 12 weist in diesem Bereich Schlitze zum Durchführen von Steckleisten 28 oder anderen Anschlußverbindungen auf. Auch in dem oberen Bereich 29 des von der Gehäusehaube 12 umschlossenen Raumes können Leiterplatten und andere Teile an mit der Montageplatte 11 verbundenen Stützwandungen 30 angeordnet sein.

Wie aus Fig. 3 ersichtlich ist, können in der Schaltgehäusewandung 16 nebeneinander mehrere Gehäuseöffnungen 17 zum Hindurchführen von Kühlschienen 15 von Montageträgern vorgesehen sein, wobei nicht von Montageträgern besetzte Öffnungen 17 durch Blinddeckel 31 verschlossen sein kön nen. Fig. 3 zeigt auch Dichtungsmanschetten 32, die an einer Kühlschiene 15 oder einem Blinddeckel 31 befestigt sein können und mit Dichtlippen 33 eine.Abdichtung der Ränder der Öffnungen 17 bewirken.

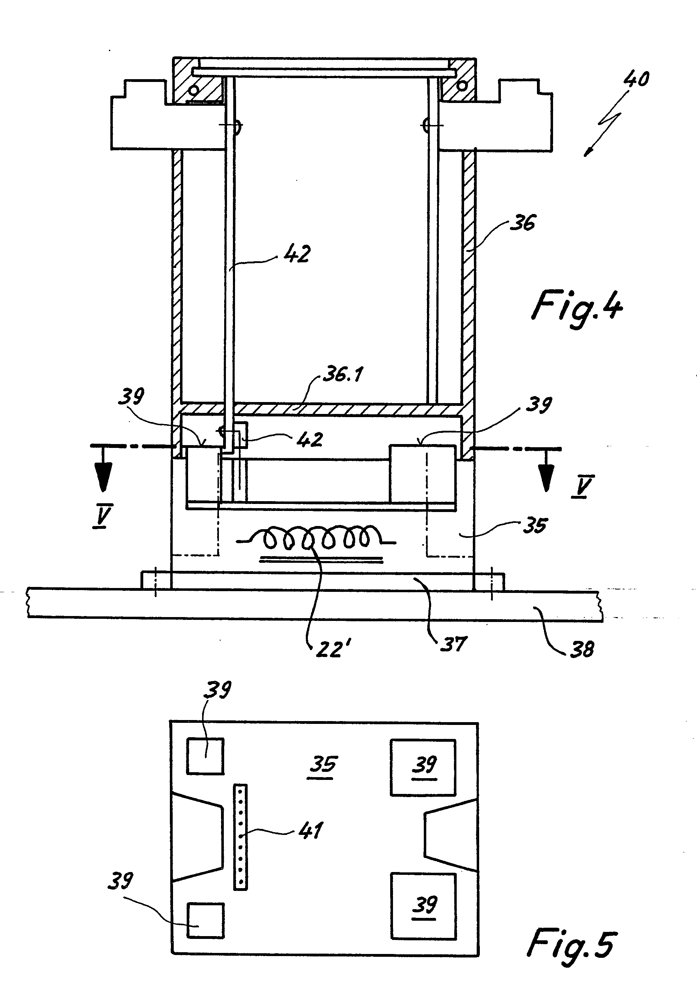

Die Fig. 4 und 5 zeigen einen Montageträger 40, der aus einem Grundgehäuse 35 und einem Aufsatzgehäuse 36 besteht. Das Grundgehäuse 35 ist in Fig. 5 in Aufsicht dargestellt. In ihm sind der kontaktlose Leistungsschalter für Heizkreise und ein in Fig. 4 nur symbolisch dargestellter Stromwandler $22'$ der elektrischen Überwachungsschaltung für Heizkreise untergebracht. Diese sich erwärmenden Schaltungsteile sind auf einer metallischen Grundplatte 37 des Grundgehäuses 35 montiert, mit welcher das Grundgehäuse auf einer metallischen Normschiene 38 eines Montagegestelles befestigt ist, so daß die Wärme aus dem Grundgehäuse 35 auf das Montagegestell abgeleitet wird. Auf der Oberseite des Grundgehäuses 35 sind vier elektrische Anschlußkontaktplatten 39 und ist eine Steckleiste 41 angeordnet. Über die Steckleiste 41 ist eine Schaltverbindung zum Aufsatzgehäuse 36 über eine Steckerleiste 42 geschaffen, die am Ende einer durch die Bodenwandung 36.1 des Aufsatzgehäuses 36 nach außen ragenden Leiterplatte 42 ausgebildet ist. Im Aufsatzgehäuse 36 sind in nicht dargestellter Weise alle Schaltungsteile, einschließlich Halbleitergebilden der Überwachungsschaltung, untergebracht, die nicht von stärkeren Strömen durchflossen sind oder wärmeempfindlich sind. Insbesondere kann das Grundgehäuse ein bekanntes sog. Solid-State-Relais enthalten, während in dem mindestens einen Aufsatzgehäuse 36 wahlweise zuge hörige Steuer-und Regelschaltungen untergebracht sein können, also die zugehörige Intelligenz, wie der Regelungsfachmann sagt.

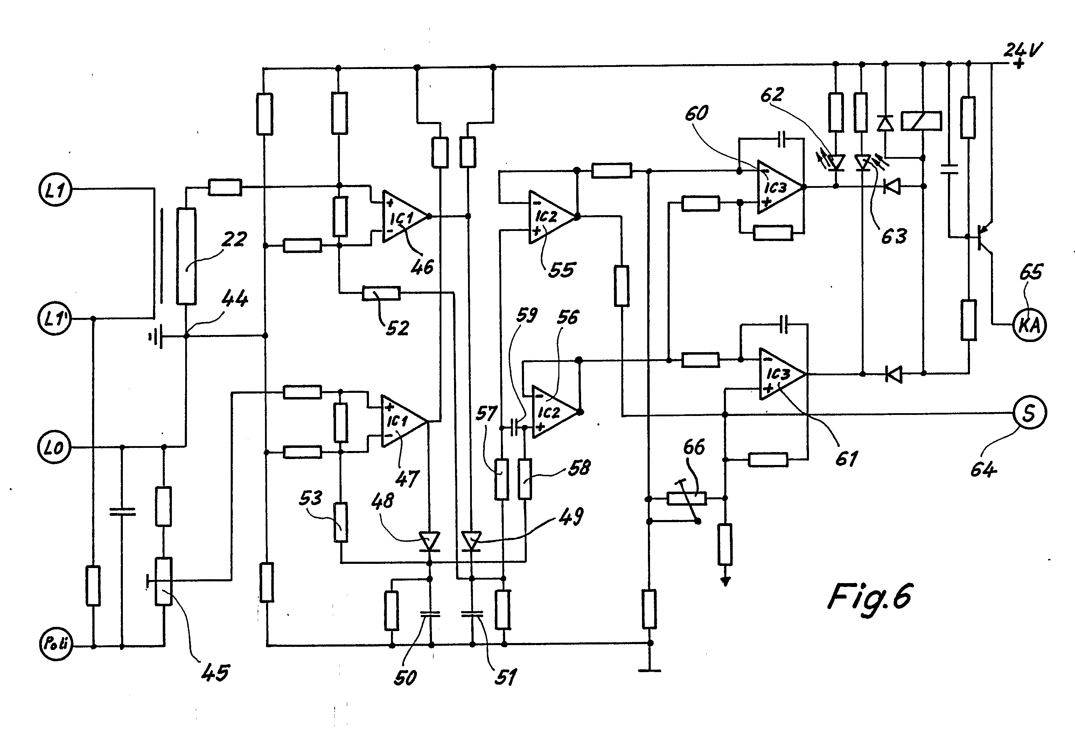

Fig. 6 zeigt ein Ausführungsbeispiel des Heizleistungs-Überwachungsteiles der auf den Montageträgern angeordneten Überwachungsschaltung für Heizkreise. Es werden nachfolgend nur die wichtigsten Teile dieser Schaltung beschrieben. Die Schaltung hat die Aufgabe, die Heizkreisen zugeführte elektrische Heizleistung auf Änderungen von größer als 100 Watt nach oben oder nach unten zu überwachen. Spannungsschwankungen, die eine Stromänderung bewirken, sollen mit der Schaltung kompensiert werden, damit sie nicht zu einer Fehlanzeige führen. Die Schaltung weist zwei Signalstrecken auf, nämlich eine erste, stromabhängige Signalstrecke, an deren Eingangsseite der bereits in Verbindung mit den Montageträgern erwähnte Stromwandler 22 angeordnet ist, sowie eine spannungsabhängige Signalstrecke, die ihren Anfang an einem Potentiometer 45 nimmt. Jede Signalstrecke führt zunächst auf einen gesonderten Operationsverstärker 46 oder 47, deren Ausgangssignale an Dioden 48 und 49 gleichgerichtet werden und zur Aufladung eines Kondensators 50 oder 51 führen. Eingangsseitig sind das eine Ende des Stromwandlers 22 und das eine Ende des Potentiometers 45 (über einen Widerstand) mit einem gemeinsamen Massepunkt 44 verbunden. Über Widerstände 52 und 53 erfolgt von den Gleichrichtern 48 oder 49 her jeweils eine Rückkoppelung auf die Operationsverstärker 46 oder 47. Beide Operationsverstärker 46 und 47 haben offene Kollektorausgänge. Die Ausgänge beider Verstärker 46 und 47 sind jeweils mit einer Diode 48 und 49 und einem anschließenden Kondensator 50 oder 51 verbunden.

Jeder der beiden Kondensatoren 50 und 51 ist mit einem zweiten, als Impedanzwandler geschalteten Operationsverstärker 55 oder 56 über einen Widerstand 57 oder 58 verbunden. Zwischen beiden Widerständen 57 und 58 ist ein Koppelungskondensator 59 angeordnet, durch welchen Laufzeitunterschiede kompensiert werden, welche durch das häufige Ein-und Ausschalten der angelegten Spannungen im Zuge der Heizkreisregelung auftreten können.

Jede Signalstrecke weist schließlich noch einen dritten Operationsverstärker 60 und 61 mit offenem Kollektorausgang auf, der jeweils als sog. Fensterdiskriminator geschaltet ist und dessen Ausgangssignal jeweils eine Leuchtdiode 62 oder 63 beeinflußt. Am Potentiometer 45 wird die spannungsabhängige Signalstrecke so abgeglichen, daß beide Leuchtdioden 62 und 63 dunkel sind. Sie leuchten auf, wenn die Heizleistung um 100 Watt überschritten oder um 100 Watt unterschritten wird. In diesem Fall wird auch ein Ausgangssignal auf einen Schaltausgang 64 und auf einen Steuerausgang 65 gegeben. An einem Potentiometer 66 wird die Schalthysterese eingestellt.

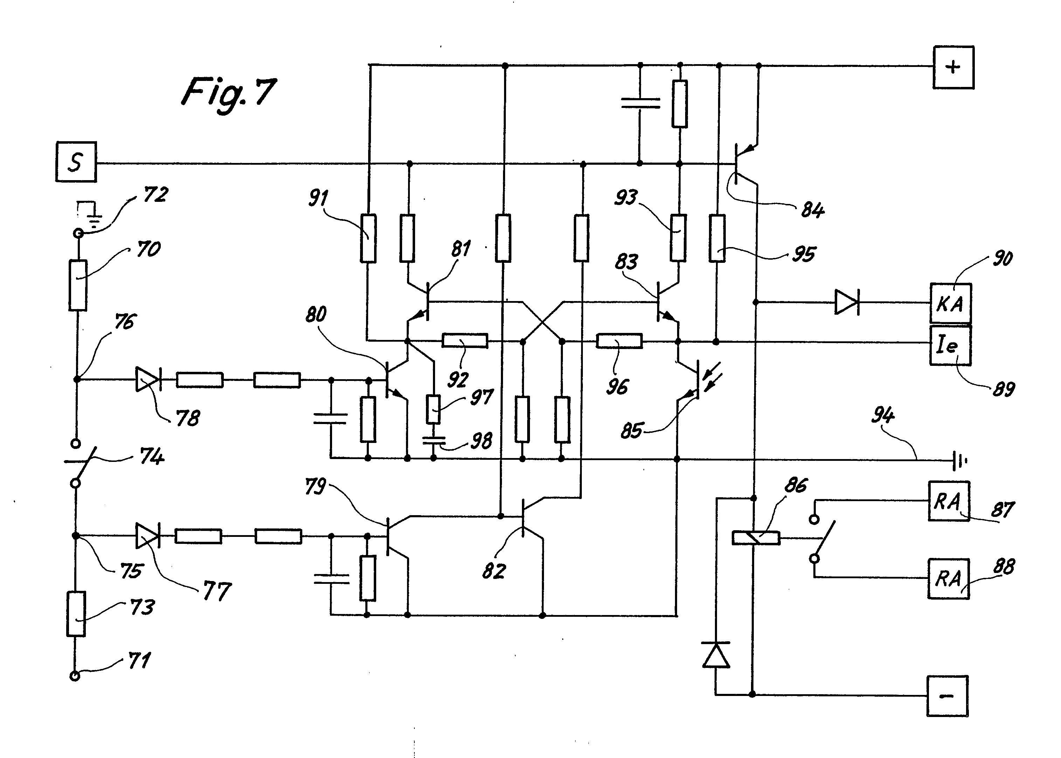

Fig. 7 zeigt ein Schaltbild des Sicherungs-und Halbleiter-Überwachungsteiles der Überwachungsschaltung. Am linken Rand der Schaltung ist der Stromversorgungsweg für die zu steuernden und überwachenden Heizwiderstände 70 dargestellt. Er verläuft zwischen den beiden Anschlußklemmen 71 und 72 und führt über eine Sicherung 73 und den bereits erwähnten kontaktlosen Leistungsschalter 74, der symbolisch als mechanischer Kontaktschalter eingezeichnet ist. Der Überwachungsteil weist zwei Eingänge auf, von denen der eine zwischen der Sicherung 73 und dem kontakt losen Leistungsschalter 74 an der Stelle 75 an den Lastkreis angeschlossen ist, während der andere Eingang zwischen dem Leistungsschalter 74 und den Heizwiderständen 70 an der Stelle 76 an den Lastkreis angeschlossen ist. Beide Eingänge führen jeweils über eine Gleichrichterdiode 77 und 78 und über Widerstände zur Basis eines Transistors 79 oder 80. Zwischen der Basis der beiden Transistoren 79, 80 und ihrem Emitter ist jeweils eine Parallelschaltung aus einem Siebkondensator und einem Widerstand gelegt. Die Schaltung enthält weitere Transistoren 81 - 85, darunter einen Durchschalttransistor 84 und einen sog. Optokoppler 85 für eine Ansteuerung des Leistungsschalters 74. Auf der Ausgangsseite des Überwachungsteiles befinden sich ein Relais 86, das eine Verbindung zwischen zwei Steuerkreisanschlüssen 87 und 88 - schafft, und zwei Anzeigesignalanschlüsse 89 und 90.

Brennt die Sicherung 73 durch, tritt an der Anschlußstelle 75 keine Wechselspannung auf. Dadurch werden die Transistoren 82 und 84 leitend, das Relais 86 spricht an, und auch am Signalanschluß 90 tritt ein Anzeigesignal auf.

Ein Halbleiterausfall kann zwei Auswirkungen haben. Entweder ergibt sich ein leitender Zustand des Leistungsschalters 74 ohne eine Ansteuerung durch den Optokoppler 85, weil ein Kurzschluß in einer Sperrschicht auftritt, wobei der leitende Zustand langsam ansteigend oder aber schlagartig erfolgen kann. Ein Ausfall kann aber auch zu einem nichtleitenden Zustand des Leistungsschalters 74 trotz einer vorhandenen Ansteuerung führen. Im einen Störungsfall tritt an der Anschlußstelle 76 keine Wechsel spannung auf. Dadurch bleibt der Transistor 80 gesperrt, und über zwei Widerstände 91 und 92 wird die Basis des Transistors 83 positiv, so daß dieser Transistor durchgesteuert wird. Gleichzeitig wird der Transistor 84 über die Transistoren 83 und 85 und einen Widerstand 93 durchgesteuert, so daß eine Signalgabe an der Signalklemme 90 erfolgt.

Im anderen erwähnten Störungsfall tritt an der Anschlußstelle 76 Wechselspannung auf, wodurch der Transistor 80 durchsteuert, dessen Emitter an eine Masseklemme 94 gelegt ist. Die Reihenschaltung eines Kondensators 98 mit einem niederohmigen Widerstand 97 zwischen Emitter und Kollektor des Transistors 80 begünstigt für gewisse Frequenzbereiche die Siebwirkung und wirkt einer Schaltungsverzögerung durch den zwischen Basis und Emitter liegenden Kondensator entgegen. Der Optokoppler 85 ist nicht angesteuert, so daß die Plusspannung über Widerstände 95 und 96 an die Basis des Transistors 81 gelangt und diesen Transistor durchschaltet. Dadurch wird auch der Transistor 84 über die Transistoren 80 und 81 durchgeschaltet und wird an der Signalklemme 90 ein Ausgangssignal erzeugt.

## Ansprüche

1. Montageträger mit einer elektrischen Überwachungsschaltung für Heizkreise mit mindestens einem kontaktlosen Leistungsschalter, dadurch gekennzeichnet, daß der kontaktlose Leistungsschalter (20) und sich erwärmende stromführende Teile der Überwachungsschaltung, insbesondere ein Stromwandler (22, 22'), auf einem die Wärme nach außen abführenden Bauteil (13, 37) oder Teil des Montageträgers (10, 40) angeordnet sind, während die übrigen, keinem starken Stromfluß unterliegenden Schaltungsteile (27) auf gesonderten Trägerteilen (25, 26, 42) montiert sind.

2. Montageträger nach Anspruch 1, dadurch gekennzeichnet, daß er ein Gehäuse (35) aufweist, das an der Stelle seiner Anlage gegen eine Trägerschiene (38) eines Schaltgestelles oder Schaltkastens mit einer metallischen Außenwandung (37) versehen ist, auf deren Innenseite die sich erwärmenden Teile (22') der Überwachungsschaltung angeordnet sind.

3. Montageträger nach Anspruch 1 oder 2, dadurch gekennzeichnet, daß die keinem starken Stromfluß unterliegenden Schaltungsteile in mindestens einem gesonderten Gehäuse (36) angordnet sind, das auf das die Wärme abführende Gehäuse (35) oder Bauteil aufgesetzt ist und mittels einer direkten oder indirekten Steckverbindung (41/42) an den Schaltungsteil mit den sich erwärmenden Bauteilen gekoppelt ist.

4. Montageträger nach einem der Ansprüche 1 bis 3, dadurch gekennzeichnet, daß die sich erwärmenden Bauteile (20, 22) der Überwachungsschaltung auf mindestens einer Platte (13) angeordnet sind, die mit einem Kühlrippenkörper (15) verbunden ist, der durch eine Öffnung (14) im Montageträgergehäuse (Montageplatte 11) nach außen ragt.

5. Montageträger nach Anspruch 4, dadurch gekennzeichnet, daß der Kühlrippenkörper (15) in einen an das Montageträgergehäuse angeformten oder ansetzbaren Kühlschacht (18) ragt.

6. Montageträger nach einem der Ansprüche 1 bis 5, dadurch gekennzeichnet, daß in einem gemeinsamen Gehäuse (Gehäusehaube, 12) die sich erwärmenden Bauteile (20, 22) mit den die Wärme nach außen führenden Teilen (13, 15) im Mittelbereich und die übrigen Schaltungsteile (27) auf daneben befindlichen Leiterplatten (25, 26) angeordnet sind.

7. Montageträger nach einem der Ansprüche 1 bis 6, dadurch gekennzeichnet, daß die Überwachungsschaltung einen Heizleistungs-Überwachungsteil aufweist, der unabhängig von Netzspannungsschwankungen arbeitet, wobei über einen einseitig geerdeten Stromwandler (22) ein vom Heizungsstrom abhängiges Signal und über ein Potentiometer (45) ein von der Netzspannung abhängiges Signal erzeugt und auf getrennte Signalstrecken eingegeben, über gegengekoppelte Operationsverstärker (46, 47) getrennt verstärkt und gleichgerichtet (Dioden 48, 49) und zum Aufladen von gesonderten Kondensatoren (50, 51) verwendet werden, und daß beide Signalstrecken - schließ lich über als Fensterdiskriminatoren geschaltete Operationssverstärker (60, 61) auf Leuchtdioden (62, 63) als Anzeigeorgane führen.

8. Montageträger nach Anspruch 7, dadurch gekennzeichnet, daß eine zusätzliche Koppelung zwischen den beiden Signalstrecken des Heizleistungs-Überwachungsteiles über einen Kondensator (59) zur Kompensation von durch unterschiedliche Aufladungszeitkonstanten auftretenden Signallaufzeitunterschieden besteht.

9. Montageträger nach einem der Ansprüche 1 bis 8, dadurch gekennzeichnet, daß die Überwachungsschaltung einen Sicherungs-und Halbleiter-Überwachungsteil umfaßt, der zwei Eingänge (75, 76) aufweist, von denen einer hinter einer Sicherung (73) und vor dem kontaktlosen Leistungsschalter (74) und einer hinter dem kontaktlosen Leistungsschalter (74) und vor den Heizungswiderständen (70) angeordnet ist und jeweils über einen Einweggleichrichter (77, 78) mit der Basis eines Transistors (79, 80) eines Anzeigeteiles verbunden ist.

0 289 888

Fig.1

Fig.3

Fig.2

Fig.4

Fig.5

Fig.6

Fig. 7